# EUROPEAN PATENT SPECIFICATION

(11) **EP 4 058 270 B1**
(45) Date of publication and mention of the grant of the patent: **07.05.2025**
(21) Application number: 20828757.3
(22) Date of filing: 16.11.2020
(51) Int. Cl.: B29C 64/259, B29C 64/20, B29C 64/124, B33Y 10/00, B33Y 30/00

(54) **STEREOLITHOGRAPHY APPARATUS AND RESIN RECEPTACLE**
STEREOLITHOGRAFIEVORRICHTUNG UND HARZBEHÄLTER
APPAREIL DE STÉRÉOLITHOGRAPHIE ET RÉCIPIENT À RÉSINE

(30) Priority: 15.11.2019 FI 20195976
(43) Date of publication of application: 21.09.2022
(73) Proprietor: Planmeca OY, 00880 Helsinki (FI)
(72) Inventor: HYVÄRINEN, Pentti, 00880 Helsinki (FI); NYHOLM, Kustaa, 00880 Helsinki (FI)
(86) International application number: PCT/FI2020/050761
(87) International publication number: WO 2021/094659

(56) References cited:
- EP-A1- 3 083 206
- EP-A1- 3 154 761
- US-A1- 2019 152 144

## Description

### TECHNICAL FIELD

This specification relates to bottom-up stereolithographic 3D printing. In particular, the specification relates to bottom-up stereolithography apparatuses and vats for such apparatuses for receiving and holding resin to be cured by electromagnetic radiation transmitted to the vat through a transparent bottom film thereof.

### BACKGROUND

In bottom-up stereolithography printing, the vat holding the curable resin from which the object to be printed is formed shall meet certain requirements.

For example, the transparent bottom film of the vat, through which the curing radiation is received to the vat to cure resin therein shall lie closely against a support surface of the stereolithography apparatus through which support surface the exposure pattern of a layer to be cured is transmitted. For example, no air bubbles should be present between the support surface and the bottom film of the vat. The bottom film shall be rigid and straight enough and it shall be mountable sufficiently firmly to the vat assembly typically comprising a metal frame forming the circumferential side wall of the vat.

On the other hand, the bottom film should be durable enough to enable repetitive cleaning thereof between different production batches. However, due to the cleaning, the bottom film unavoidably wears out gradually and becomes also less transparent. Therefore, the bottom film shall be changed occasionally. This, in turn, requires the mounting of the bottom film to the vat assembly to be releasable.

Patent application publication WO 2015/092717 discloses a cartridge comprising a container with a transparent bottom, for use in a stereolithography machine.

The above requirements set limitations to the usability of the conventional vat assemblies. Therefore, there is a need for improved vat assembly configurations.

### SUMMARY

This summary is provided to introduce a selection of concepts that are further described below in the Detailed Description. This Summary is not intended to definitely identify key features or essential features of the claimed subject matter, nor is it intended to be used to limit the scope of the claimed subject matter.

In one aspect, a bottom-up stereolithography apparatus (SLA) is disclosed. The SLA comprises a support surface and a vat assembly for forming a vat having a transparent bottom film, the vat being configured to be placed on the support surface to receive and hold a resin curable by electromagnetic radiation transmitted to the vat through the transparent bottom film thereof.

The vat assembly comprises a circumferential first frame part having a first lower surface defining a bottom level of the vat assembly, and a circumferential first inner side surface extending from the first lower surface to an upper level elevated from the bottom level in a thickness direction of the circumferential first frame part and defining a recess within the circumferential first frame part.

The apparatus comprises an air channel and an evacuating arrangement configured to suck air from the recess of the circumferential first frame part via the air channel.

Thereby a receptacle, at least partially formed of a transparent film material and comprising a bowl may be placed in the vat assembly with the bowl in the recess. Then, with the thereby formed vat being placed on the support surface with the first lower surface of the circumferential first frame part against the support surface, air can be evacuated from the recess via the air channel to stretch the bowl against the support surface and the first inner side surface.

The part of the receptacle, which then lies against the support surface, forms the transparent bottom film of the vat.

In a second aspect, a receptacle is disclosed which is at least partially formed of a transparent film material and comprises a bowl.

The receptacle is configured to be placed in a vat assembly in accordance with the first aspect with the bowl in the recess of the vat assembly to form a vat.

In a third aspect, a method is disclosed for forming a vat by placing a receptacle of the second aspect in the vat assembly of the first aspect with the bowl of the receptacle in the recess, and evacuating air from the recess via the air channel to stretch the bowl against the support surface and the circumferential first inner side surface.

The part of the receptacle, which then lies against the support surface, forms the transparent bottom film of the vat.

### BRIEF DESCRIPTION OF THE DRAWINGS

The accompanying drawings, which illustrate various embodiments, together with the description help to explain the principles of the embodiments. In the drawings:
FIG. 1 shows a cross sectional exploded view of a vat assembly and a receptacle placeable in the vat assembly;
FIG. 2 shows cross sectional views of a part of a bottom-up stereolithography apparatus;
FIG. 3 shows a perspective cross sectional view of a vat assembly and a receptacle placeable in the vat assembly;
FIG. 4 shows a cross sectional view of a part of a bottom-up stereolithography apparatus; and
FIGs. 5 and 6 show perspective and cross-sectional views of receptacles.

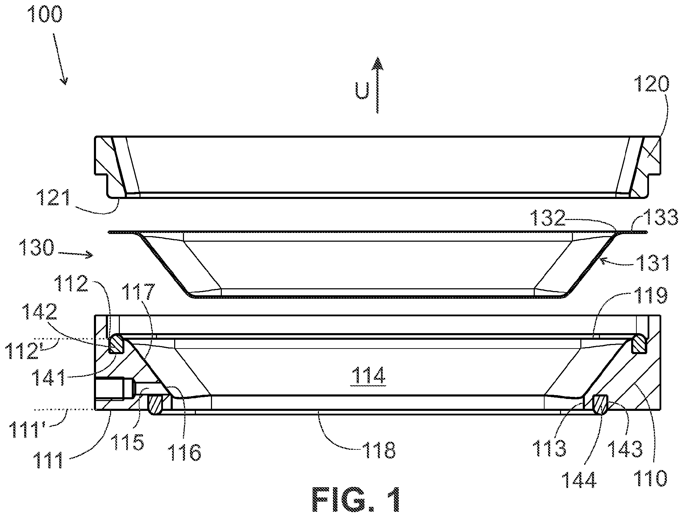

FIGs. 1 to 6 are not drawn to scale.

### DETAILED DESCRIPTION

The detailed description provided below in connection with the appended drawings is intended as a description of a number of embodiments. It is not intended to represent the only forms in which the embodiments may be constructed, implemented, or utilized.

One or more of the embodiments and examples discussed below may advantageously enable forming a vat for a bottom-up stereolithography apparatus and process utilizing a low-cost disposable receptacle forming the transparent bottom film of the vat.

The vat assembly 100 of FIG. 1 may be used to form a vat having a transparent bottom film. Such vat can be used in a bottom-up stereolithography apparatus to receive and hold a resin which is cured by electromagnetic radiation which is transmitted to the vat through the bottom surface thereof.

"Stereolithography" refers to a 3D printing technique wherein the actual "printing" of a material layer is based on curing a layer of a curable resin by electromagnetic radiation such as visible or ultraviolet light. Such printing enables accurate manufacturing of various 3D objects. A stereolithography apparatus can also be called a stereolithographic 3D printer, or a stereolithographic additive manufacturing apparatus.

A stereolithography apparatus may be, for example, configured to, or used to, fabricate dental objects, such as dental splints, models, surgical guides, temporary fillings, and orthodontic models with high precision and efficiency.

Additionally, or alternatively, a stereolithography apparatus may be, for example, configured to, or used to, fabricate any other types of 3D-printable objects, such as jewels or various mechanical components or prototypes or spare parts of such.

In bottom-up stereolithography apparatuses and processes, the object to be printed is formed of a curable resin received to and held in a vat having a transparent bottom film. A pattern of electromagnetic radiation is transmitted through the bottom film to the vat to cure a layer of the resin at the bottom of the vat. The object to be printed is formed layer by layer onto a build surface of a build platform which is raised upwards after curing of each layer.

The actual exposure pattern of the curing electromagnetic radiation may be produced, for example, by a radiative element and a masking element partially masking the radiation emitted by the radiative element. Such radiative element and a masking element may be positioned underneath a transparent part of a support surface of a table of the SLA. A radiative element may comprise one or more radiation sources of any appropriate type, such as an array of light-emitting diode (LED) elements. A masking element may comprise, for example, a liquid crystal panel or element.

The vat assembly 100 of FIG. 1 comprises a circumferential first frame part 110.

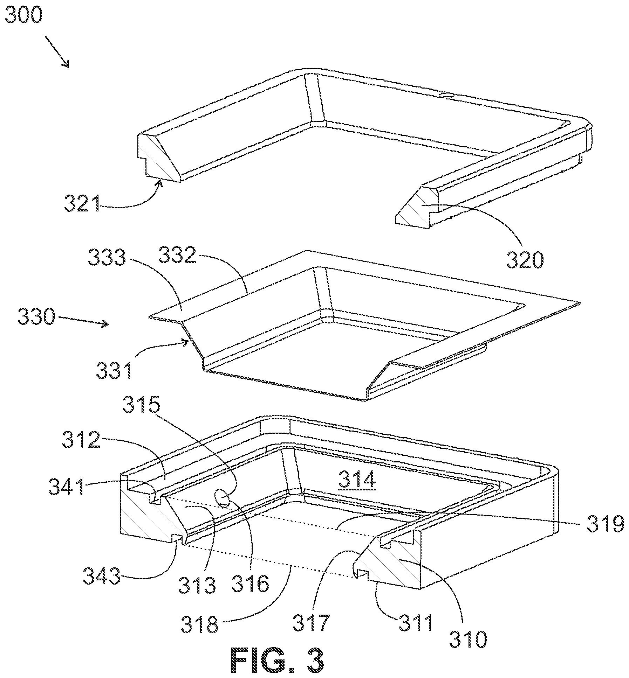

"Circumferential" nature of an object such as a body or a surface refers to a configuration of the object forming a closed loop along a circumference surrounding an open center or inner area or volume. Basically, such circumference may have any shape, such as circular, oval, elliptical, or rectangular. In the example of FIG. 1, the shape of the first frame part 110 and the circumference thereof may be, for example, substantially rectangular with rounded corners. One example of a vat assembly with such substantially rectangular circumferential configuration is illustrated FIG. 3.

The circumferential first frame part has first lower surface 111 defining a bottom level 111' of the vat assembly, and a first upper surface 112 defining an upper level 112' elevated from the first lower surface and the bottom level in a thickness direction of the first frame part. The overall circumferential configuration of the first frame part results in the first lower and upper surfaces also being circumferential.

In the example of FIG. 1, each of the first upper surface and first lower surface is substantially planar, and those surfaces extend substantially parallel to each other. The circumferential first lower and upper surfaces therefore encircle and define planar openings 118, 119.

The "elevation" of the first upper surface from the first lower surface in a thickness direction of the first frame part refers to the first frame part having a thickness. The first "upper" surface being "elevated" from the first lower surface defines an "upward" direction U of the vat assembly being directed, in a fictitious coordinate system fixed to the vat assembly, from the first lower surface 111 towards the first upper surface 112. Said upwards direction U is marked by an arrow in FIG. 1. Naturally, in the standard coordinate system fixed to the Earth, said "upward" direction may deviate from the real upward direction, depending on the positioning of the vat assembly.

The first lower and upper surfaces 111, 112 are connected via or by a circumferential first inner side surface 113.

"Inner" refers to the side of said surface on the inner side of the circumference of the first frame part 110, the first inner side surface 113 thus facing towards the inner volume enclosed by the circumferential first frame part. Said inner volume, defined in the lateral directions by the circumferential first inner side surface 113, forms a recess 114 within the first frame part 110.

Advantageously, the first frame part comprises an air channel 115 which opens to the recess 114 through the circumferential first inner side surface 113.

The air channel 115 "opening" to the recess 114 through the circumferential first inner side surface refers to the air channel having an open end in the form of an opening 116 at the circumferential first inner side surface 113. Air or any other gas can flow between the recess and the air channel through the opening 116.

In the example of FIG. 1, the air channel 115 opens at its other end to the outside of the first frame part. Any appropriate air evacuating arrangement may be connected to that other end for sucking or evacuating air from the recess. Then, the air channel may connect the evacuating arrangement and the recess of the first circumferential first frame part.

The vat assembly 100 of FIG. 1 further comprises a circumferential second frame part 120. The circumferential second frame part has a second lower surface 121 which is, due to the circumferential configuration of the second frame part, circumferential. The second frame part 120 is dimensioned and shaped so that it may be releasably mounted on the first frame part 110 with the circumferential second lower surface 121 facing towards the circumferential first upper surface 112.

Said releasable mounting may be implemented by any other appropriate means, such as one or more screw attachments, clamps, etc.

Other embodiments may be implemented without any second frame part.

The first and the second frame parts 110, 120 may be formed of any appropriate material(s). For example, such material may comprise a metal, such as aluminum or steel, or a plastic material.

FIG. 1 also illustrates an example receptacle 130 comprising a bowl 131 having a circumferential upper rim 132 and a circumferential flange 133 extending laterally from the upper rim.

The receptacle 130 of FIG. 1 is shaped and dimensioned so as to be placed in the vat assembly 100 with its bowl 131 in the recess 114 of the first frame part 110 and its flange 133 lying on the first upper surface 112 of the first frame part 110. Then, with the second and the first frame parts 110, 120, being mounted together as described above, the receptacle 130 may have the flange 133 thereof lying and pressed between the second lower surface 112 of the first frame part 110 and the second lower surface 121 of the second frame part 120.

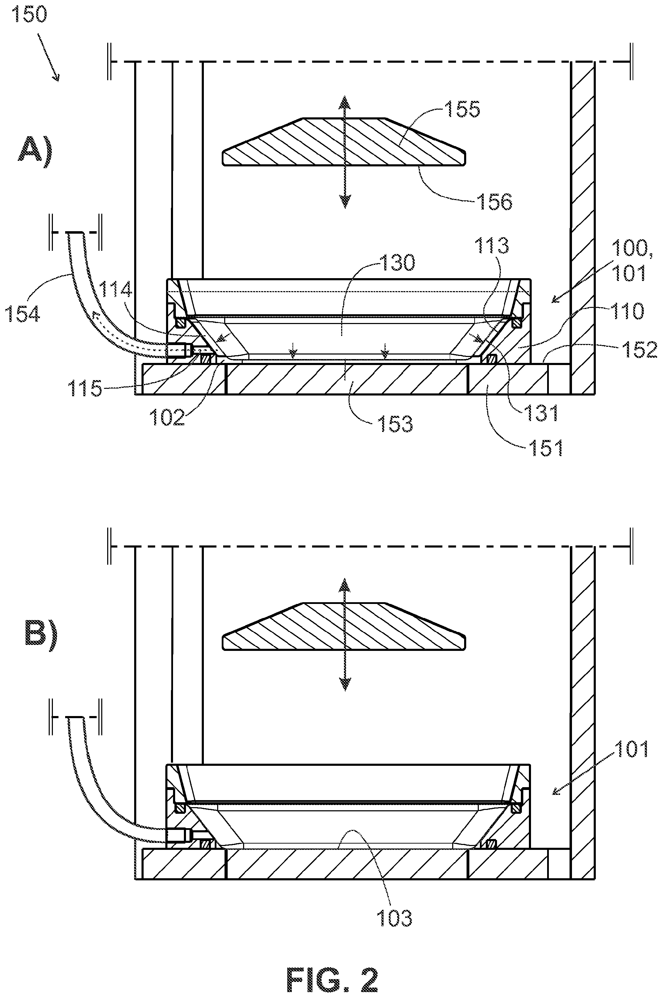

A vat thereby formed and its use in a stereolithography apparatus (SLA) is illustrated in FIG 2.

The stereolithography apparatus 150 of FIG. 2 is of a bottom-up type. In a bottom-up SLA, resin held by a vat is cured layer by layer at the bottom of the vat by curing electromagnetic radiation transmitted to the vat through the transparent bottom film thereof. The object to be printed is formed on the build surface 156 of a build platform 155 which is vertically movable as marked by an arrow in the drawings of FIG. 2.

The SLA has a table 151 forming a support surface 152. The table comprises a radiation transmission part 153 which may comprise a transparent plate enabling radiation from an external radiation source to be transmitted through it. Alternatively, the transmission part 153 may comprise an exposure arrangement producing the curing electromagnetic radiation.

An exposure arrangement may comprise, for example, one or more light emitting diodes (LEDs) possible arranged in an array as a radiation source. An exposure arrangement may further comprise a masking element, such as a liquid crystal panel, to partially mask the radiation emitted by a radiation source. A mask may thereby form the actual exposure pattern for each layer to be cured.

As illustrated in the drawings of FIG. 2, a vat 101 formed, as described above with reference to FIG. 1, utilizing a vat assembly 100 is placed on the support surface 152 of the SLA 150, at the location of the radiation transmission part 153. Then, a closed volume 102 is formed in the recess 114 between the vat assembly 100 and the table 151 of the SLA as illustrated in drawing A of FIG. 2. The closed volume is defined by the support surface 152, the circumferential first inner side surface 113 of the first frame part 110 and the bowl 131 of the receptacle 130.

The recess 114 of the first frame part 110, defined by the circumferential first inner side surface 113, has a specific recess shape. Correspondingly, the recess has a specific recess volume. In the example of FIG. 1 and 2, such recess volume may be considered as being defined by the first inner side surface 113 and the planar openings 118, 119 encircled by the first upper and lower surfaces 111, 112 of the first frame part 110.

The bowl 131 of the receptacle 130 correspondingly has, in its non-stretched rest position, a bowl rest shape substantially following the recess shape and a bowl rest volume slightly smaller than the recess volume of the first frame part 110. The bowl may further have one or more stretched positions.

The bowl rest volume may cover, for example, less than or equal to 95 %, for example, less than or equal to 80 % of the recess volume. The slightly smaller size of the bowl may enable stretching of the bowl against the first frame part 110 and the support surface 152 as discussed below.

The SLA 150 comprises an evacuating arrangement having an air pipe 154. In the drawing of FIG. 2, the air pipe is connected to the air channel 115 so that air can be sucked or evacuated from the recess 114 via the air channel, connecting the evacuating arrangement and the recess, as marked in drawing A) of FIG. 2 by a dashed arrow. Vacuum thereby formed in the closed volume 102 may advantageously stretch the bowl 131 of the receptacle 130 towards the circumferential inner side surface 113 of the first frame part 110 and the support surface 152, as marked by four arrows in drawing A) of FIG. 2. In results, as illustrated in drawing B) of FIG. 2, the receptacle then becomes pressed against the circumferential inner side surface 113 of the first frame part 110 and the support surface 152. The part of the receptacle 130 which lies against the support surface 152 of the table 151 of the SLA forms then an at least partially transparent bottom film 103 of the vat 101.

The receptacle 130 is formed of a transparent film material which may comprise, for example, fluorinated ethylene propylene FEP. FEP may provide sufficient optical transparency for proper and accurate curing of the layers of the object to be printed by exposure to radiation transmitted through the bottom film 103 of the vat. FEP may also provide sufficient rigidity of the bottom film, and enable manufacturing of the receptacle easily, for example, by thermoforming. The film may have a wall thickness, for example, of about 0.3 mm or less. Even as low thicknesses as 0.1 mm or less may be used.

In other embodiments, it is possible that a receptacle is only partially formed of a transparent film material. Thus, it is possible that only a part of the receptacle, namely the part forming the transparent bottom film in the final vat assembly, is formed of the transparent film material. The rest of the receptacle may then be formed of an opaque or less transparent material.

For effecting the air sucking or evacuating, the evacuating arrangement may comprise any appropriate vacuum means, such as an air pump, connected to the air pipe 154. Instead of an air pump, vacuum means may comprise, for example, any appropriate arrangement with a mechanically adjustable closed volume connected to the air channel to suck or evacuate air from the recess by enlarging the closed volume. Such evacuating arrangement may be integrated to the SLA or to the vat assembly itself.

Several advantages may be achievable by a vat assembly, receptacle, vat, and SLA discussed above with reference to FIGs. 1 and 2.

For example, the vat assembly 100 in which a separate receptable 130 may be placed to easily form the complete vat 101 allow using disposable receptacles. Then, each production batch may be printed, or each printing operation may be carried out, using a disposable receptable. Then, there is no need for cleaning the vat from residual resin.

A disposable receptacle may be filled with resin when in use. In an alternative embodiment, a disposable receptable may be ready filled with a resin beforehand. Such pre-filled receptable may optionally be closed by a film to be removed before use.

Embodiments with the vat assembly 100 having also the second frame part 120 makes forming the vat 101 and changing the receptacle 130 thereof simple.

The air channel 115 of the first frame part 110, allowing evacuating air from the recess 114 and stretching the bowl 131 of the receptacle 130 placed in the vat assembly, further greatly improves the feasibility of the vat assembly 100. First of all, it enables ensuring that the bottom film of the vat lies conformally against the support surface of the SLA onto which the vat is placed even if the bottom part of the bowl itself is not completely straight when the bowl is in its rest position. This allows the receptacle to be formed of a very thin film, which may provide savings in the material costs. Further, the film being stretched against the support surface due to evacuation of air via the air channel may enable controlled peeling of the cured layer off the bottom film of the vat.

In the example vat assembly 110 of FIGs. 1 and 2, the circumferential first inner side surface 113 comprises a circumferential conical section 117. The conical section may be tilted, for example, by an angle of 10 to 45 degrees relative to the upwards thickness direction U of the first frame part. The circumferential conical section 117 of the first inner side surface 113 defining the recess 114 in the lateral direction makes the recess extend upward in the thickness direction, thus in the upwards thickness direction U.

In other embodiments, substantially vertical circumferential first side surfaces without a conical section may be used. In yet other embodiments, a conical section may cover a part of a circumferential first inner side surface only, whereby such conical section is thus not itself circumferential.

Receptacles with bowl rest shapes substantially following the recess shape of a first frame part of a vat assembly may be manufactured, for example, by thermoforming or molding. A conical section of the circumferential first inner side surface of a first frame part may facilitate such manufacturing by enabling thermoforming of molding tools to have a proper draft. A draft may facilitate relieving the completed receptacle from the tool, such as a mold, by means of which the shape of the bowl is defined in the manufacturing process.

In addition to creating the vacuum, the air channel 115 may also be used to adjust the vacuum and the force by which the receptable is pressed against the inner side surface 113 of the first frame part 110 and the support surface 152 of the SLA 150. For example, for raising the build platform 154 after completion of curing a layer of the resin, the vacuum may be slightly relieved. This may allow the bottom film 103 of the vat 101 to bend upwards to facilitate smooth and controlled peeling of the cured layer off the bottom film.

In the example of FIGs. 1 and 2, the first frame part 110 comprises a circumferential upper sealing groove 141 formed on the first upper surface 112, in which upper sealing groove an upper gasket 142 is placed. The upper sealing groove and such upper gasket may serve as upper sealing means which may form an air-tight sealing between the first upper surface 112 of the first frame part and the flange 133 of the receptacle 130 placed in the vat assembly.

In other embodiments, any other appropriate types of upper sealing means may be used. For example, the lower surface of the flange of a receptacle may have a layer of an adhesive or sealing agent, or a gasket, thereon.

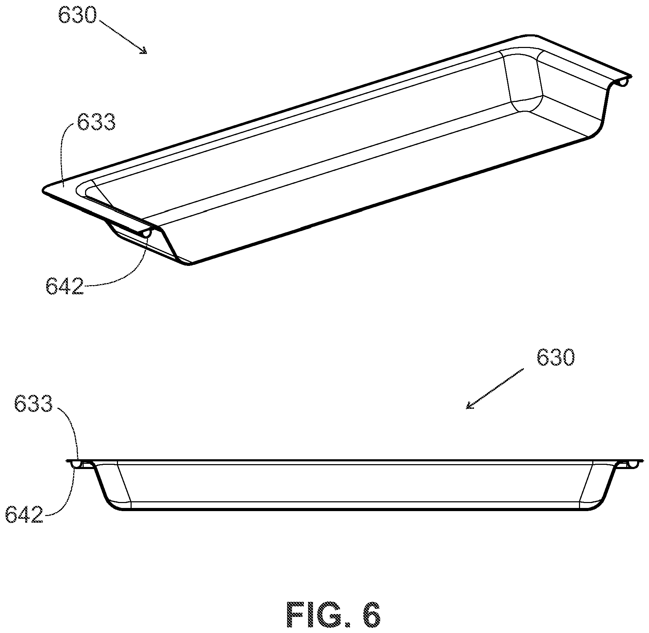

Such layer or gasket may enable implementation of a vat assembly without any second frame part for pressing the flange of the receptacle between the first upper surface of a first frame part and a second lower surface of the second frame part of the vat assembly. An example of a gasket integrated in the flange of a receptacle is discussed below with reference to FIG. 6.

In yet other embodiments, it may be possible to implement vat assemblies and SLA configurations without any upper sealing means.

The first frame part of the example of FIGs. 1 and 2 further comprises a circumferential lower sealing groove 143 formed on the first lower surface 111 of the first frame part 110, in which lower sealing groove a lower gasket 144 is placed. The lower sealing groove and such lower gasket may serve as lower sealing means which may form an air-tight sealing between the first lower surface and the support surface 152 of the SLA 150.

In other embodiments, any other appropriate types of lower sealing means may be used. For example, in some embodiments, sealing between the support surface of an SLA and a first frame part of a vat assembly may be achieved by sealing means formed or placed in or on the support surface instead of in or on the first lower surface of a first frame part. Such sealing means may comprise, correspondingly to the sealing means of the example of FIGs. 1 and 2, a sealing groove formed on the support surface and a gasket positioned in that groove. In some embodiment, a sealing groove may be formed on one of the first lower surface of a first frame part and the support surface of an SLA, and a gasket may be mounted on the other one of those surfaces so as to be placed into the groove when the vat assembly is placed on the support surface. Such arrangement may additionally serve for aligning the vat assembly and the support surface properly relative to each other.

It may also be possible to implement vat assemblies and SLA configurations without any lower sealing means.

In the embodiments discussed above with reference to FIG. 2, the vat assembly 100 may belong to the SLA. The vat assembly 100 may be placed on the support surface 152 of the SLA 150 in a releasable manner or it may lie thereon without any mounting. If the vat assembly belongs to the SLA, the vat assembly may be mounted on the support surface of the vat with the air evacuating arrangement connected to the air channel of the first frame part of the vat assembly.

It is to be noted that the above embodiments and examples are not limiting or exclusive examples of all possible vat assemblies, receptacles, vats, and/or stereolithography apparatuses within the scope of this specification. Instead, any further embodiments and variants thereof may be implemented within the scope of the claims.

For example, the shapes and/or dimensions of the vat assemblies may be different from those of FIGs. 1 and 2. One example is illustrated in FIG. 3.

The vat assembly 300 and receptacle 330 of FIG. 3 are basically in accordance with those of FIGs. 1 and 2. However, there are differences in the shapes and relative dimensions. For example, the first lower and upper surfaces 311, 312 of the first frame part 310, and the second lower surface 321 of the second frame part 320, are wider than those in the example of FIGs. 1 and 2. Also the shape of the circumferential first inner side surface 313 is slightly different from that of the example of FIGs. 1 and 2. There are corresponding differences in the shapes and dimensions of the receptacle 330 also. Further, no gaskets are illustrated in the upper and lower sealing grooves 341, 343.

Even further variations in the shapes and/or dimensions of the vat assembly are possible in other embodiments. For example, vat assemblies may be implemented having a first frame part without any specific first upper surface. Also then the circumferential first inner surface may extend from the first lower surface to an upper level elevated from the bottom level in the thickness direction. In such embodiments, a receptable placeable in the vat assembly with its bowl in the recess may lack any specific flange extending laterally from the upper rim of the bowl.

In such embodiments, if the vat assembly comprises a circumferential second frame part, that may be shaped and dimensioned so that instead of a flange, some other circumferential mounting part of the receptacle placed in the vat assembly may lie between the first and the second frame parts. "Mounting" refers to such circumferential part serving as a part from which the receptacle may be releasably mounted to the vat assembly by having it pressed between the first and the second frame parts.

On the other hand, in such embodiments, upper sealing means may be used which may form an air-tight sealing between the first frame part and a receptacle in any appropriate location. For example, a gasket may be arranged on the circumferential first inner side surface.

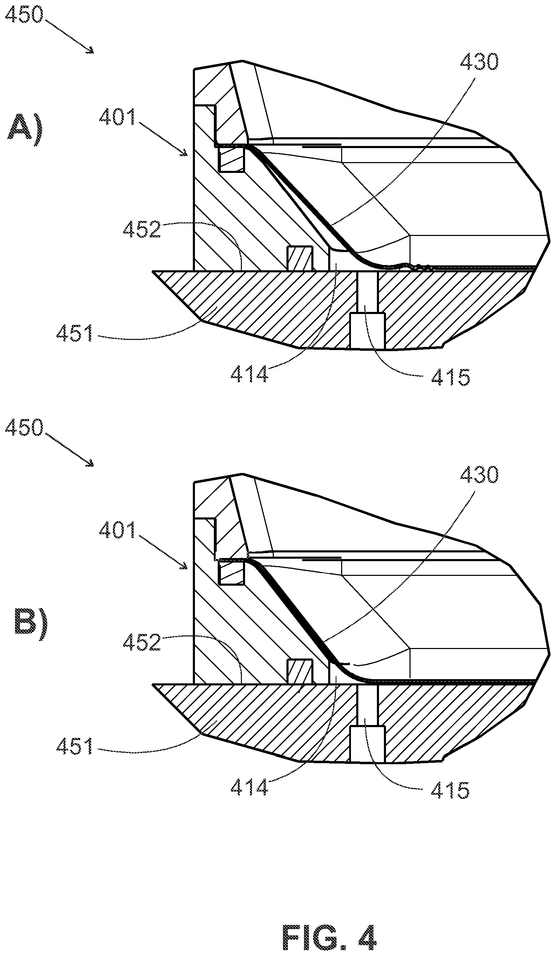

Variations are also possible e.g. in the location of the air channel. One example is illustrated in FIG. 4.

The SLA 450 FIG. 4 may be basically in accordance with any of those discussed above with references to FIGs. 1 to 3. The SLA 450 of FIG. 4 distinguishes from those in that there is an air channel 415 arranged so as to lie in the table 451 and open to the recess 414, when the vat 401 lies on the support surface 452, through the support surface.

The drawings of FIG. 4 also illustrate the stretching of the receptable 430 against the support surface 452 and the circumferential first inner side surface 413. In drawing A), the bowl of the non-stretched receptable 430 is a bit smaller than the volume of the recess 414, and the film forming the receptacle of the receptacle is even a bit wavy. Drawing B) illustrates the receptable 430 as stretched to is stretched position by evacuating air from the recess 414 via the air channel 415.

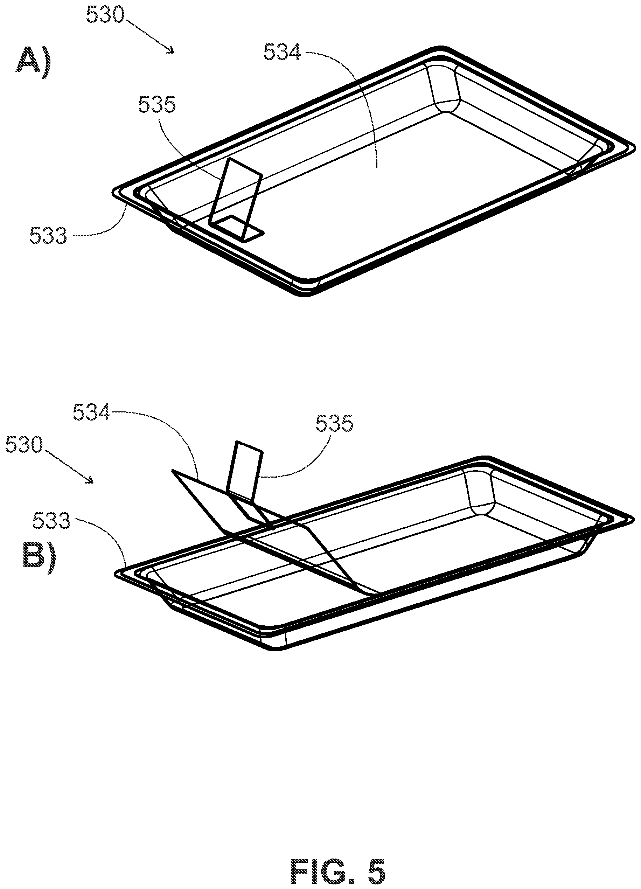

The receptacle 530 of FIG. 5, which may be disposable, may be basically in accordance with any of those discussed above with reference to FIGs. 1 to 4. It distinguishes from those in that it has a lid 534 closing the receptacle as illustrated in drawing A.

In the example of FIG. 5, the lid 534 is illustrated as being transparent. In other embodiments, a lid may be non-transparent.

The lid 534 is formed as a thin film which may be formed of, for example, some suitable plastic material. A non-transparent lid may be formed of, for example, a thin foil of aluminum or some other metal.

In the example of FIG. 5, the lid is attached to the flange 533 of the receptacle. In other embodiments, a lid may be attached to some other part of a receptacle. The attachment may be implemented, for example, by gluing the lid 534 to the receptacle 530. In other embodiments, a mechanical attachment based on specific complementary shapes of a lid and a receptacle may be used.

The lid 534 is removable. In the example of FIG. 5, the lid 534 may be removed by peeling or ripping the lid off the receptacle 530 as illustrated in drawing B showing the lid partially detached from the flange 533 of the receptacle. To facilitate gripping the lid for the removal thereof, a tab 535 is attached to the lid. In other embodiments, instead of a tab, a lid itself may have some specific portion or protrusion enabling gripping the lid for peeling or ripping it off.

The removable lid 534 enables providing a receptacle which is pre-filled with resin. Then, the user of the SLA may take a ready-to-use receptacle, place it into the vat assembly and peel or rip off the cover thereof. After use, the remaining resin may be cured, and the receptacle together with the cured resin may be disposed as normal waste.

The receptacle 630 of FIG. 6, illustrated in a perspective sectional view and side sectional view, may be basically in accordance with any of those discussed above with reference to FIGs. 1 to 5. For example, it may have a lid as that described above with reference to FIG. 5.

The receptacle 630 distinguishes from those other receptacles in that it has an upper gasket 642 mounted on the lower surface of the flange 633 of the receptacle.

The upper gasket 642 integrated in the flange 633 may serve for forming a sealing between the receptacle and a vat assembly in a complete vat formed by placing the receptacle 630 in a vat assembly which may be basically in accordance with any of those discussed above. The first frame part of such vat assembly may comprise a circumferential upper sealing groove formed on the first upper surface thereof, in which upper sealing groove the upper gasket 642 of the flange 633 is placeable. Then, differently from the example of FIGs. 1 and 2, the upper sealing means of the vat assembly itself does not need to include any upper gasket.

In other embodiments, an upper gasket may lie elsewhere in a receptacle, for example, on the outer surface of the bowl.

It will be understood that the benefits and advantages described above may relate to one embodiment or example or may relate to several embodiments or examples. It will further be understood that reference to 'an' item refers to one or more of those items.

The term "comprising" is used in this specification to mean including the feature(s) followed thereafter, without excluding the presence of one or more additional features.

### REFERENCE SIGNS

100/300 vat assembly
101/401 vat
102 closed volume formed in the vat assembly
103 transparent bottom film of the vat
110/310 first frame part
111/311 first lower surface
112/312 first upper surface
113/313 first inner side surface
114/314/414 recess
115/315/415 air channel
116/316 opening at the first inner side surface
117/317 conical section of the first inner side surface
118/318 opening defined by the first lower surface
119/319 opening defined by the first upper surface
120/320 second frame part
121/321 second lower surface
130/330/430/530/630 receptacle
131/331 bowl
132/332 upper rim of the bowl
133/333/533/633 flange of the receptacle
534 lid
535 tab
141/341 upper sealing groove
142/642 upper gasket
143/343 lower sealing groove
144 lower gasket
150/450 stereolithography apparatus (SLA)
151/451 table
152/452 support surface
153 radiation transmission part
154 air pipe
155 build platform
156 build surface

## Claims

1. A bottom-up stereolithography apparatus (SLA) (150) comprising a support surface (152) and a vat assembly (100) for forming a vat (101), the vat (101) having a transparent bottom film (103), the vat (101) being configured to be placed on the support surface (152) to receive and hold a resin curable by electromagnetic radiation transmitted to the vat (101) through the transparent bottom film (103) thereof; the vat assembly (100) comprising a circumferential first frame part (110) having a first lower surface (111) defining a bottom level (111') of the vat assembly (100), and a circumferential first inner side surface (113) extending from the first lower surface (111) to an upper level (112') elevated from the bottom level (111') in a thickness direction of the circumferential first frame part (110) and defining a recess (114) within the circumferential first frame part (110); wherein the apparatus (150) comprises an air channel (115) and an evacuating arrangement (154) configured to suck air from the recess (114) of the circumferential first frame part (110) via the air channel (115); whereby a receptacle (130), at least partially formed of a transparent film material and comprising a bowl (131) may be placed in the vat assembly (100) with the bowl (131) in the recess (114) so that, with the thereby formed vat (101) being placed on the support surface (152) with the first lower surface (111) of the circumferential first frame part (110) against the support surface (152), air can be evacuated from the recess (114) via the air channel (115) to stretch the bowl (131) against the support surface (152) and the circumferential first inner side surface (113), the part of the receptacle (130), which then lies against the support surface (152), forming the transparent bottom film (103) of the vat (101).

2. A stereolithography apparatus (150) as defined in claim 1, wherein the circumferential first inner side surface (113) comprises a circumferential conical section (117) so that the recess (114) extends upwards in the thickness direction.

3. A stereolithography apparatus (150) as defined in claim 1 or 2, wherein the circumferential first frame part (110) has a first upper surface (112) elevated from the first lower surface (111) and the bottom level (111') defined thereby in the thickness direction so as to define the upper level (112'), the circumferential first inner side surface (113) connecting the first lower and upper surfaces (111, 112), whereby the receptacle (130), further having a circumferential upper rim (132) and a circumferential flange (133) extending laterally from the circumferential upper rim (132), may be placed in the vat assembly (100) with the circumferential flange (133) lying on the first upper surface (112) of the circumferential first frame part (110).

4. A stereolithography apparatus (150) as defined in any of claims 1 to 3, further comprising a circumferential second frame part (120) configured to be releasably mounted on the circumferential first frame part (110) whereby a circumferential mounting part (133) of the receptacle (130) placed in the vat assembly (100) may lie between the circumferential first and second frame parts (110, 120).

5. A stereolithography apparatus (150) as defined in claims 3 and 4, wherein the circumferential second frame part (120) has a second lower surface (121) facing, with the circumferential second frame part (120) releasably mounted on the circumferential first frame part (110), towards the first upper surface (112), whereby the circumferential flange (133) of the receptacle (130) may lie between the second lower surface (121) and the first upper surface (112).

6. A stereolithography apparatus (150) as defined in any of claims 1 to 5, comprising upper sealing means (141, 142) for forming an air-tight sealing between the circumferential first frame part (110) and the receptacle (130) placed in the vat assembly (100).

7. A stereolithography apparatus (150) as defined in claim 6, wherein the upper sealing means (141, 142) are sealing means for forming an air-tight sealing between the first upper surface (112) and the circumferential flange (133) of the receptacle (130) placed in the vat assembly (100).

8. A stereolithography apparatus (150) as defined in claim 7, wherein the upper sealing means (141, 142) comprise a circumferential upper sealing groove (141) formed on the first upper surface (112) for placing an upper gasket (142) in the circumferential upper sealing groove (141).

9. A stereolithography apparatus (150) as defined in any of claims 1 to 8, further comprising lower sealing means (143, 144) for forming an air-tight sealing between the first lower surface (111) and the support surface (152) of a bottom-up stereolithography apparatus (150) on which the vat assembly (100) is placed when in use.

10. A stereolithography apparatus (150) as defined in claim 9, wherein the lower sealing means (143, 144) comprise a circumferential lower sealing groove (143) formed on the first lower surface (111) for placing a lower gasket (144) in the circumferential lower sealing groove (143).

11. A stereolithography apparatus (150) as defined in claim 10, wherein, with the vat (101) being placed on the support surface (152), the air evacuating arrangement (154) is connected to the air channel (115).

12. A stereolithography apparatus (150) as defined in any of claims 1 to 11, wherein the air channel (115) lies in the circumferential first frame part (110) and opens to the recess (114) through the circumferential first inner side surface (113).

13. A stereolithography apparatus (150, 450) as defined in any of claims 1 to 11, comprising a table (451) defining the support surface (452), wherein the air channel (415) lies in the table (451) and opens, with the vat (401) being placed on the support surface (152, 452), to the recess (114, 414) through the support surface (152, 452).

14. A receptacle (130) at least partially formed of a transparent film material and comprising a bowl (131), the receptacle (130) being configured to be placed in a vat assembly (100) as defined in any of claims 1 to 13 with the bowl (131) in the recess (114) of the vat assembly (100) to form a vat (101).

15. A receptacle (130) as defined in claim 14, the bowl of which having a circumferential upper rim (132) and the receptacle (130) further comprising a circumferential flange (133) extending laterally from the circumferential upper rim (132), wherein the receptable (130) is configured to be placed in the vat assembly (100) with the circumferential flange (133) lying on the first upper surface (112) of the circumferential first frame part (110).

16. A receptacle (130) as defined in claim 15, the recess (114) of the vat assembly (100) having a recess shape and a recess volume, wherein the bowl (131) has, in a non-stretched rest position, a bowl rest shape substantially following the recess shape and a bowl rest volume covering less than or equal to 95 % of the recess volume.

17. A receptacle (130) as defined in any of claims 14 to 16, wherein the transparent film material comprises fluorinated ethylene propylene FEP.

18. A receptacle (130) as defined in any of claims 14 to 17, wherein the receptacle (130) has an average wall thickness less than or equal to 0.3 mm, such as less than or equal to 0.1 mm.

19. A receptacle (130) as defined in any of claims 14 to 18, wherein the receptacle (130) is disposable.

20. A receptable (130, 530) as defined in any of claims 14 to 19, being pre-filled with resin and further comprising a removable lid (534) closing the receptacle (130, 530).

21. A receptacle (130, 630) as defined in any of claims 14 to 20, further comprising an upper gasket (642) for forming a sealing between the receptacle (130, 630) and a vat assembly (100).

22. A receptacle (130, 630) as defined in claims 15 and 21, wherein the upper gasket (642) lies on a lower surface of the circumferential flange (133, 633) of the receptacle (130, 630).

23. A stereolithography apparatus (150) as defined in any of the claims 1 to 13, having a receptacle (130) as defined in any of the claims 14 to 22 placed in the vat assembly (100) with the bowl (131) of the receptacle (130) in the recess (114) formed by the circumferential first inner side surface (113) of the circumferential first frame part (110); the bowl (131) being stretched against the support surface (152) and the circumferential first inner side surface (113) by means of vacuum formed by evacuating air from the recess (114) via the air channel (115); the part of the receptacle (130), which then lies against the support surface (152), forming the transparent bottom film (103) of the thereby formed vat (101).

24. A method of forming a vat (101), the method comprising
placing a receptacle (130) as defined in any of the claims 14 to 22 in a vat assembly (100) of a stereolithography apparatus (150) as defined in any of the claims 1 to 13 with the bowl (131) of the receptacle (130) in the recess (114) formed by the circumferential first inner side surface (113) of the circumferential first frame part (110); and
evacuating air from the recess (114) via the air channel (115) to stretch the bowl (131) against the support surface (152) and the circumferential first inner side surface (113), the part of the receptacle (130), which then lies against the support surface (152), forming the transparent bottom film (103) of the vat (101).

## Patentansprüche

1. Bottom-up-Stereolithografievorrichtung (SLA) (150), mit einer Trägerfläche (152) und einer Behältnisanordnung (100) zum Bilden eines Behältnisses (101), wobei das Behältnis (101) eine transparente Bodenfolie (103) aufweist, wobei das Behältnis (101) konfiguriert ist, um auf der Trägerfläche (152) angeordnet zu werden, um ein Harz aufzunehmen und zu halten, das durch elektromagnetische Strahlung härtbar ist, die durch die transparente Bodenfolie (103) des Behältnisses (101) auf das Behältnis (101) übertragen wird; wobei die Behältnisanordnung (100) einen umlaufenden ersten Rahmenteil (110) mit einer ersten unteren Fläche (111), die eine untere Ebene (111') der Behältnisanordnung (100) definiert, und einer umlaufenden ersten inneren Seitenfläche (113) aufweist, die sich von der ersten unteren Fläche (111) zu einer oberen Ebene (112') erstreckt, die von der unteren Ebene (111') in einer Dickenrichtung des umlaufenden ersten Rahmenteils (110) erhöht ist, und eine Aussparung (114) innerhalb des umlaufenden ersten Rahmenteils (110) definiert; wobei die Vorrichtung (150) einen Luftkanal (115) und eine Absauganordnung (154) aufweist, die konfiguriert ist, um Luft aus der Aussparung (114) des umlaufenden ersten Rahmenteils (110) über den Luftkanal (115) anzusaugen; wobei ein Behälter (130), der zumindest teilweise aus einem transparenten Folienmaterial gebildet ist und eine Schale (131) aufweist, in der Behältnisanordnung (100) mit der Schale in der Aussparung (114) angeordnet werden kann, so dass, wenn das dadurch gebildete Behältnis (101) auf der Trägerfläche (152) mit der ersten unteren Fläche (111) des umlaufenden ersten Rahmenteils (110) gegen die Trägerfläche angeordnet wird, Luft aus der Aussparung (114) über den Luftkanal (115) abgesaugt werden kann, um die Schale (131) gegen die Trägerfläche (152) und die umlaufende erste innere Seitenfläche (113) zu spannen, wobei der Teil des Behälters (130), der dann gegen die Trägerfläche (152) liegt, die transparente Bodenfolie (103) des Behältnisses (101) bildet.

2. Stereolithografievorrichtung (150) nach Anspruch 1, wobei die umlaufende erste innere Seitenfläche (113) einen umlaufenden konischen Abschnitt (117) aufweist, so dass sich die Aussparung (114) in der Dickenrichtung nach oben erstreckt.

3. Stereolithografievorrichtung (150) nach Anspruch 1 oder 2, wobei der umlaufende erste Rahmenteil (110) eine erste obere Fläche (112) aufweist, die von der ersten unteren Fläche (111) und der dadurch definierten unteren Ebene (111') in der Dickenrichtung erhöht ist, um die obere Ebene (112') zu definieren, wobei die umlaufende erste innere Seitenfläche (113) die erste untere und obere Fläche (111, 112) verbindet, wobei der Behälter (130), der ferner einen umlaufenden oberen Rand (132) und einen umlaufenden Flansch (133) aufweist, der sich seitlich von dem umlaufenden oberen Rand (132) erstreckt, in der Behältnisanordnung (100) angeordnet werden kann, wobei der umlaufende Flansch (133) auf der ersten oberen Fläche (112) des umlaufenden ersten Rahmenteils (110) liegt.

4. Stereolithografievorrichtung (150) nach einem der Ansprüche 1 bis 3, die ferner einen umlaufenden zweiten Rahmenteil (120) aufweist, der konfiguriert ist, um lösbar an dem umlaufenden ersten Rahmenteil (110) montiert zu werden, wobei ein umlaufendes Montageteil (133) eines Behälters (130), der in der Behältnisanordnung (100) angeordnet ist, zwischen dem umlaufenden ersten und zweiten Rahmenteil liegen kann.

5. Stereolithografievorrichtung (150) nach den Ansprüchen 3 und 4, wobei der umlaufende zweite Rahmenteil (120) eine zweite untere Fläche (121) aufweist, die, wenn der umlaufende zweite Rahmenteil (120) lösbar an dem umlaufenden ersten Rahmenteil (110) montiert ist, der ersten oberen Fläche (112) zugewandt ist, wobei der umlaufende Flansch (133) des Behälters (130) zwischen der zweiten unteren Fläche (121) und der ersten oberen Fläche (112) liegen kann.

6. Stereolithografievorrichtung (150) nach einem der Ansprüche 1 bis 5, die ferner ein oberes Dichtungsmittel (141, 142) zum Bilden einer luftdichten Abdichtung zwischen dem umlaufenden ersten Rahmenteil (110) und dem Behälter (130), der in der Behältnisanordnung (100) angeordnet ist, aufweist.

7. Stereolithografievorrichtung (150) nach den Ansprüchen 3 und 6, wobei das obere Dichtungsmittel (141, 142) ein Dichtungsmittel zum Bilden einer luftdichten Abdichtung zwischen der ersten oberen Fläche (112) und dem umlaufenden Flansch (133) eines Behälters (130) ist, der in der Behältnisanordnung (100) angeordnet ist.

8. Stereolithografievorrichtung (150) nach Anspruch 7, wobei das obere Dichtungsmittel eine umlaufende obere Dichtungsnut (141) aufweist, die an der ersten oberen Fläche (112) zum Anordnen einer oberen Dichtung (142) in der oberen umlaufenden Nut ausgebildet ist.

9. Stereolithografievorrichtung (150) nach einem der Ansprüche 1 bis 8, die ferner ein unteres Dichtungsmittel (143, 144) zum Bilden einer luftdichten Abdichtung zwischen der ersten unteren Fläche (111) und der Trägerfläche (152) einer Bottom-up-Stereolithografievorrichtung (150), auf der die Behältnisanordnung im Gebrauch angeordnet ist, aufweist.

10. Stereolithografievorrichtung (150) nach Anspruch 9, wobei das untere Dichtungsmittel (143, 144) eine umlaufende untere Dichtungsnut (143) aufweist, die an der ersten unteren Fläche (111) zum Anordnen einer unteren Dichtung (144) in der unteren umlaufenden Nut (143) ausgebildet ist.

11. Stereolithografievorrichtung (150) nach Anspruch 10, wobei, wenn das Behältnis (101) auf der Trägerfläche (152) angeordnet ist, die Luftabsauganordnung (154) mit dem Luftkanal (115) verbunden ist.

12. Stereolithografievorrichtung (150) nach einem der Ansprüche 1 bis 11, wobei der Luftkanal (115) in dem umlaufenden ersten Rahmenteil (110) liegt und sich durch die erste innere Seitenfläche (113) zu der Aussparung (114) öffnet.

13. Stereolithografievorrichtung (450) nach einem der Ansprüche 1 bis 11, die einen Tisch (451) aufweist, der die Trägerfläche (452) definiert, wobei der Luftkanal (415) in dem Tisch (451) liegt und sich, wenn das Behältnis (401) auf der Trägerfläche (452) angeordnet ist, durch die Trägerfläche (452) zu der Aussparung (414) öffnet.

14. Behälter (130), der zumindest teilweise aus einem transparenten Folienmaterial gebildet ist und eine Schale (131) aufweist, wobei der Behälter (130) konfiguriert ist, um in einer Behältnisanordnung (100) nach einem der Ansprüche 1 bis 13 angeordnet zu werden, wobei sich die Schale (131) in der Aussparung (114) der Behältnisanordnung (100) befindet, um ein Behältnis (101) zu bilden.

15. Behälter (130) nach Anspruch 14, dessen Schale einen umlaufenden oberen Rand (132) aufweist und der Behälter (130) ferner einen umlaufenden Flansch (133) aufweist, der sich seitlich von dem umlaufenden oberen Rand (132) erstreckt, wobei der Behälter (130) konfiguriert ist, um in der Behältnisanordnung (100) angeordnet zu werden, wobei der umlaufende Flansch (133) auf der ersten oberen Fläche (112) des umlaufenden ersten Rahmenteils (110) liegt.

16. Behälter (130) nach Anspruch 15, wobei die Aussparung (114) der Behältnisanordnung (100) eine Aussparungsform und ein Aussparungsvolumen aufweist, wobei die Schale (131) in einer nicht gestreckten Ruheposition eine Schalenruheform, die im Wesentlichen der Aussparungsform folgt, und ein Schalenruhevolumen aufweist, das kleiner oder gleich 95 % des Aussparungsvolumens abdeckt.

17. Behälter (130) nach einem der Ansprüche 14 bis 16, wobei das transparente Folienmaterial fluoriertes Ethylenpropylen FEP aufweist.

18. Behälter (130) nach einem der Ansprüche 14 bis 17, wobei der Behälter (130) eine durchschnittliche Wanddicke von kleiner oder gleich 0,3 mm, wie etwa kleiner oder gleich 0,1 mm, aufweist.

19. Behälter (130) nach einem der Ansprüche 14 bis 18, wobei der Behälter (130) ein Einwegartikel ist.

20. Behälter (130, 530) nach einem der Ansprüche 14 bis 19, der mit Harz vorgefüllt ist und ferner einen abnehmbaren Deckel (534) aufweist, der den Behälter (130, 530) verschließt.

21. Behälter (130, 630) nach einem der Ansprüche 14 bis 20, der ferner eine obere Dichtung (642) zum Bilden einer Abdichtung zwischen dem Behälter (130, 630) und einer Behältnisanordnung (100) aufweist.

22. Behälter (130, 630) nach den Ansprüchen 15 und 21, wobei die obere Dichtung (642) auf der unteren Fläche des umlaufenden Flansches (133, 633) des Behälters (130, 630) liegt.

23. Stereolithografievorrichtung (150) nach einem der Ansprüche 1 bis 13, die einen Behälter (130) nach einem der Ansprüche 14 bis 22 aufweist, der in der Behältnisanordnung (100) angeordnet ist, wobei sich die Schale (131) des Behälters (130) in der Aussparung (114) befindet, die durch die umlaufende erste innere Seitenfläche (113) des umlaufenden ersten Rahmenteils (110) gebildet wird; wobei die Schale (131) gegen die Trägerfläche (152) und die umlaufende erste innere Seitenfläche (113) mittels eines Vakuums gestreckt wird, das durch Absaugen von Luft aus der Aussparung (114) über den Luftkanal (115) gebildet wird; wobei der Teil des Behälters (130), der dann gegen die Trägerfläche (152) liegt, die transparente Bodenfolie (103) des dadurch gebildeten Behältnisses (101) bildet.

24. Verfahren zum Bilden eines Behältnisses (101), wobei das Verfahren das
Anordnen eines Behälters (130) nach einem der Ansprüche 14 bis 22 in einer Behältnisanordnung (100) einer Stereolithografievorrichtung (150) nach einem der Ansprüche 1 bis 13 aufweist, wobei sich die Schale (131) des Behälters (130) in der Aussparung (114) befindet, die durch die umlaufende erste innere Seitenfläche (113) des umlaufenden ersten Rahmenteils (110) gebildet wird; und
Absaugen von Luft aus der Aussparung (114) über den Luftkanal (115), um die Schale (131) gegen die Trägerfläche (152) und die umlaufende erste innere Seitenfläche (113) zu strecken, wobei der Teil des Behälters (130), der dann gegen die Trägerfläche (152) liegt, die transparente Bodenfolie (103) des Behältnisses (101) bildet.

## Revendications

1. Appareil de stéréolithographie ascendante (SLA) (150) comprenant une surface de support (152) et un ensemble cuve (100) pour former une cuve (101), la cuve (101) présentant un film inférieur transparent (103), la cuve (101) étant configurée pour être placée sur la surface de support (152) pour recevoir et contenir une résine durcissable par rayonnement électromagnétique émis vers la cuve (101) à travers le film inférieur transparent (103) de celle-ci ; l'ensemble cuve (100) comprenant une première partie de cadre circonférentielle (110) présentant une première surface inférieure (111) définissant un niveau inférieur (111') de l'ensemble cuve (100) et une première surface latérale intérieure circonférentielle (113) s'étendant de la première surface inférieure (111) à un niveau supérieur (112') surélevé par rapport au niveau inférieur (111') dans le sens de l'épaisseur de la première partie de cadre circonférentielle (110) et définissant un évidement (114) à l'intérieur de la première partie de cadre circonférentielle (110) ;
dans lequel l'appareil (150) comprend un canal d'air (115) et un agencement d'évacuation (154) configuré pour aspirer l'air de l'évidement (114) de la première partie de cadre circonférentielle (110) via le canal d'air (115) ; selon lequel un récipient (130), au moins partiellement formé d'un matériau de film transparent et comprenant un corps (131) peut être placé dans l'ensemble cuve (100) avec le corps (131) dans l'évidement (114) de sorte que, avec la cuve (101) ainsi formée étant placée sur la surface de support (152) avec la première surface inférieure (111) de la première partie de cadre circonférentielle (110) contre la surface de support (152), l'air peut être évacué de l'évidement (114) via le canal d'air (115) pour étirer le corps (131) contre la surface de support (152) et la première surface latérale intérieure circonférentielle (113), la partie du récipient (130), qui repose alors contre la surface de support (152), formant le film inférieur transparent (103) de la cuve (101).

2. Appareil de stéréolithographie (150) tel que défini dans la revendication 1, dans lequel la première surface latérale intérieure circonférentielle (113) comprend une section conique circonférentielle (117) de sorte que l'évidement (114) s'étend vers le haut dans le sens de l'épaisseur.

3. Appareil de stéréolithographie (150) tel que défini dans la revendication 1 ou 2, dans lequel la première partie de cadre circonférentielle (110) présente une première surface supérieure (112) surélevée par rapport à la première surface inférieure (111) et le niveau inférieur (111') défini par celle-ci dans le sens de l'épaisseur de manière à définir le niveau supérieur (112'), la première surface latérale intérieure circonférentielle (113) reliant les premières surfaces inférieure et supérieure (111, 112), selon lequel le récipient (130), présentant en outre un bord supérieur circonférentiel (132) et une bride circonférentielle (133) s'étendant latéralement à partir du bord supérieur circonférentiel (132), peut être placé dans l'ensemble cuve (100) avec la bride circonférentielle (133) reposant sur la première surface supérieure (112) de la première partie de cadre circonférentielle (110).

4. Appareil de stéréolithographie (150) tel que défini dans l'une quelconque des revendications 1 à 3, comprenant en outre une seconde partie de cadre circonférentielle (120) configurée pour être montée de manière amovible sur la première partie de cadre circonférentielle (110), selon lequel une partie de montage circonférentielle (133) du récipient (130) placé dans l'ensemble cuve (100) peut se trouver entre les première et seconde parties de cadre circonférentielles (110, 120).

5. Appareil de stéréolithographie (150) tel que défini dans les revendications 3 et 4, dans lequel la seconde partie de cadre circonférentielle (120) présente une seconde surface inférieure (121) orientée, avec la seconde partie de cadre circonférentielle (120) montée de manière amovible sur la première partie de cadre circonférentielle (110), vers la première surface supérieure (112), selon lequel la bride circonférentielle (133) du récipient (130) peut se trouver entre la seconde surface inférieure (121) et la première surface supérieure (112).

6. Appareil de stéréolithographie (150) tel que défini dans l'une quelconque des revendications 1 à 5, comprenant des moyens d'étanchéité supérieurs (141, 142) destinés à former une étanchéité à l'air entre la première partie de cadre circonférentielle (110) et le récipient (130) placé dans l'ensemble cuve (100).

7. Appareil de stéréolithographie (150) tel que défini dans la revendication 6, dans lequel les moyens d'étanchéité supérieurs (141, 142) sont des moyens d'étanchéité destinés à former une étanchéité à l'air entre la première surface supérieure (112) et la bride circonférentielle (133) du récipient (130) placé dans l'ensemble cuve (100).

8. Appareil de stéréolithographie (150) tel que défini dans la revendication 7, dans lequel les moyens d'étanchéité supérieurs (141, 142) comprennent une rainure d'étanchéité supérieure circonférentielle (141) formée sur la première surface supérieure (112) pour placer un joint supérieur (142) dans la rainure d'étanchéité supérieure circonférentielle (141).

9. Appareil de stéréolithographie (150) tel que défini dans l'une quelconque des revendications 1 à 8, comprenant en outre des moyens d'étanchéité inférieurs (143, 144) destinés à former une étanchéité à l'air entre la première surface inférieure (111) et la surface de support (152) d'un appareil de stéréolithographie ascendante (150) sur lequel l'ensemble cuve (100) est placé lors de son utilisation.

10. Appareil de stéréolithographie (150) tel que défini dans la revendication 9, dans lequel les moyens d'étanchéité inférieurs (143, 144) comprennent une rainure d'étanchéité inférieure circonférentielle (143) formée sur la première surface inférieure (111) pour placer un joint inférieur (144) dans la rainure d'étanchéité inférieure circonférentielle (143).

11. Appareil de stéréolithographie (150) tel que défini dans la revendication 10, dans lequel, avec la cuve (101) étant placée sur la surface de support (152), l'agencement d'évacuation d'air (154) est relié au canal d'air (115).

12. Appareil de stéréolithographie (150) tel que défini dans l'une quelconque des revendications 1 à 11, dans lequel le canal d'air (115) se trouve dans la première partie de cadre circonférentielle (110) et s'ouvre vers l'évidement (114) à travers la première surface latérale intérieure circonférentielle (113).

13. Appareil de stéréolithographie (150, 450) tel que défini dans l'une quelconque des revendications 1 à 11, comprenant une table (451) définissant la surface de support (452), dans lequel le canal d'air (415) se trouve dans la table (451) et s'ouvre, avec la cuve (401) étant placée sur la surface de support (152, 452), vers l'évidement (114, 414) à travers la surface de support (152, 452).

14. Récipient (130) au moins partiellement formé d'un matériau de film transparent et comprenant un corps (131), le récipient (130) étant configuré pour être placé dans un ensemble cuve (100) tel que défini dans l'une quelconque des revendications 1 à 13 avec le corps (131) dans l'évidement (114) de l'ensemble cuve (100) pour former une cuve (101).

15. Récipient (130) tel que défini dans la revendication 14, dont le corps présente un bord supérieur circonférentiel (132) et le récipient (130) comprenant en outre une bride circonférentielle (133) s'étendant latéralement à partir du bord supérieur circonférentiel (132), dans lequel le récipient (130) est configuré pour être placé dans l'ensemble cuve (100) avec la bride circonférentielle (133) reposant sur la première surface supérieure (112) de la première partie de cadre circonférentielle (110).

16. Récipient (130) tel que défini dans la revendication 15, l'évidement (114) de l'ensemble cuve (100) présentant une forme d'évidement et un volume d'évidement, dans lequel le corps (131) présente, dans une position de repos non étirée, une forme de corps au repos suivant sensiblement la forme d'évidement et un volume de corps au repos couvrant 95 % ou moins du volume de l'évidement.

17. Récipient (130) tel que défini dans l'une quelconque des revendications 14 à 16, dans lequel le matériau de film transparent comprend de l'éthylène-propylène fluoré FEP.

18. Récipient (130) tel que défini dans l'une quelconque des revendications 14 à 17, dans lequel le récipient (130) présente une épaisseur de paroi moyenne inférieure ou égale à 0,3 mm, telle que inférieure ou égale à 0,1 mm.

19. Récipient (130) tel que défini dans l'une quelconque des revendications 14 à 18, dans lequel le récipient (130) est jetable.

20. Récipient (130, 530) tel que défini dans l'une quelconque des revendications 14 à 19, prérempli de résine et comprenant en outre un couvercle amovible (534) fermant le récipient (130, 530).

21. Récipient (130, 630) tel que défini dans l'une quelconque des revendications 14 à 20, comprenant en outre un joint supérieur (642) pour former une étanchéité entre le récipient (130, 630) et un ensemble cuve (100).

22. Récipient (130, 630) tel que défini dans les revendications 15 et 21, dans lequel le joint supérieur (642) repose sur une surface inférieure de la bride circonférentielle (133, 633) du récipient (130, 630).

23. Appareil de stéréolithographie (150) tel que défini dans l'une quelconque des revendications 1 à 13, présentant un récipient (130) tel que défini dans l'une quelconque des revendications 14 à 22 placé dans l'ensemble cuve (100) avec le corps (131) du récipient (130) dans l'évidement (114) formé par la première surface latérale intérieure circonférentielle (113) de la première partie de cadre circonférentielle (110) ; le corps (131) étant étiré contre la surface de support (152) et la première surface latérale intérieure circonférentielle (113) au moyen d'un vide formé en évacuant l'air de l'évidement (114) via le canal d'air (115) ; la partie du récipient (130), qui repose alors contre la surface de support (152), formant le film inférieur transparent (103) de la cuve (101) ainsi formée.

24. Procédé de formation d'une cuve (101), le procédé comprenant
le placement d'un récipient (130) tel que défini dans l'une quelconque des revendications 14 à 22 dans un ensemble cuve (100) d'un appareil de stéréolithographie (150) tel que défini dans l'une quelconque des revendications 1 à 13 avec le corps (131) du récipient (130) dans l'évidement (114) formé par la première surface latérale intérieure circonférentielle (113) de la première partie de cadre circonférentielle (110) ; et
l'évacuation de l'air de l'évidement (114) via le canal d'air (115) pour étirer le corps (131) contre la surface de support (152) et la première surface latérale intérieure circonférentielle (113), la partie du récipient (130) qui repose alors contre la surface de support (152) formant le film inférieur transparent (103) de la cuve (101).
